# EUROPÄISCHE PATENTSCHRIFT

(11) **EP 1 062 088 B1**
(45) Veröffentlichungstag und Bekanntmachung des Hinweises auf die Patenterteilung: **18.06.2003**
(21) Anmeldenummer: 99907626.8
(22) Anmeldetag: 12.03.1999
(51) Int. Cl.: B30B 11/02, B30B 15/06, C23C 16/26, C23C 16/30

(54) **Tablettierwerkzeug**
Tabletting tool
Outil pour la fabrication de comprimés

(30) Priorität: 13.03.1998 DE 29804550 U; 13.03.1998 DE 19810969; 30.09.1998 US 164417
(43) Veröffentlichungstag der Anmeldung: 27.12.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: HIEKE, André, D-38162 Hordorf (DE); GRISCHKE, Martin, FL-9494 Schaan (LI); BRAND, Jochen, D-38126 Braunschweig (DE)
(74) Vertreter: Einsel, Martin
(86) Internationale Anmeldenummer: EP9901608
(87) Internationale Veröffentlichungsnummer: WO99047346

(56) Entgegenhaltungen:
- EP-A- 0 509 875
- EP-A- 0 625 588
- EP-A- 0 885 983
- DE-U- 29 619 564
- US-A- 4 851 808
- US-A- 5 008 002
- US-A- 5 026 415
- US-A- 5 266 398
- US-A- 5 352 493
- PATENT ABSTRACTS OF JAPAN vol. 097, no. 011, 28. November 1997 & JP 09 194216 A (CANON INC), 29. Juli 1997
- PATENT ABSTRACTS OF JAPAN vol. 097, no. 002, 28. Februar 1997 & JP 08 259241 A (CANON INC), 8. Oktober 1996
- PATENT ABSTRACTS OF JAPAN vol. 096, no. 006, 28. Juni 1996 & JP 08 040731 A (CANON INC), 13. Februar 1996
- PATENT ABSTRACTS OF JAPAN vol. 016, no. 443 (C-0985), 16. September 1992 & JP 04 154634 A (CANON INC), 27. Mai 1992
- PATENT ABSTRACTS OF JAPAN vol. 016, no. 443 (C-0985), 16. September 1992 & JP 04 154633 A (CANON INC), 27. Mai 1992
- PATENT ABSTRACTS OF JAPAN vol. 015, no. 052 (C-0803), 7. Februar 1991 & JP 02 283627 A (ASAHI OPTICAL CO LTD), 21. November 1990
- PATENT ABSTRACTS OF JAPAN vol. 014, no. 314 (C-0737), 5. Juli 1990 & JP 02 107532 A (CANON INC), 19. April 1990
- PATENT ABSTRACTS OF JAPAN vol. 018, no. 585 (M-1700), 9. November 1994 & JP 06 218587 A (HITACHI TOOL ENG LTD), 9. August 1994

## Beschreibung

Die Erfindung betrifft ein Tablettierwerkzeug zum Verpressen von fließfähigen Feststoffen, insbesondere pulverförmigen Feststoffen, mit formgebenden Presswerkzeugen zu Tabletten, bei dem zumindest die formgebenden Oberflächen der Presswerkzeuge mit einer adhäsionshemmenden Beschichtung versehen sind.

In Pressvorrichtungen bzw. Pressen wird der pulverförmige Feststoff oder pastöse Stoff unter hohem Druck zu einem mechanisch stabilen Formkörper verpreßt bzw. kompaktiert. Zu diesem Zweck müssen die Preßwerkzeuge so ausgelegt sein, daß sie die hohen Preßkräfte aufnehmen können. Ein typischen Beispiel für derartige Preßvorrichtungen sind Tablettierwerkzeuge, in denen beispielsweise Tabletten für die pharmazeutische Industrie hergestellt werden.

Andere Anwendungsbereiche sind etwa die Herstellung von Tabletten für Wasch- und Spülmaschinen, die Herstellung von gepreßten Lebensmitteln, wie sie für Fertiggerichte oder aber auch für Hunde- und Katzennahrung bekannt ist, und außerdem auch die Herstellung von Hartmetallprodukteri oder keramischen Produkten, wo Grünlinge mit derartigen Preßwerkzeugen hergestellt werden.

Ein regelmäßiges Problem bei der Herstellung von gepreßten Produkten aus pulverförmigen oder pastösen Feststoffen mit Hilfe von derartigen formgebenden Preßwerkzeugen besteht darin, daß Teile des zu formenden Rohmaterials am Prägeelements des Preßwerkzeugs oder in der gegenüberliegenden Matrize haften bleiben. Dies verhindert eine fehlerfreie Herstellung des Produktes, da Teile desselben nach dem Herstellungsverfahren fehlen.

Dieses Problem wird besonders evident bei der Herstellung von pharmazeutischen Produkten, bei denen es auf eine exakte Dosierung der im Produkt enthaltenen Wirkstoffe ankommt, die auf diese Weise nicht mehr gewährleistet werden kann.

Gewünscht wird auch eine genau definierte Oberflächenbeschaffenheit und mechanische Stabilität der gepreßten Produkte. Die Oberfläche soll nach Möglichkeit glatt sein, wobei auch in Betracht gezogen werden kann, sehr konkrete Beschriftungen etwa hinsichtlich Typs oder Marke des fraglichen Produktes während des Prägevorgangs einzubringen. Gerade dann kommt es natürlich ebenfalls wesentlich darauf an, daß keine Störung der Oberfläche beim Preßvorgang durch Haftenbleiben von Rohmaterialpartikeln am Preßwerkzeug auftreten kann.

Jede Aufrauhung der Oberfläche der Preßwerkzeuge bewirkt eine verstärkte Neigung zur Haftung des Rohmaterials an den Oberflächen. Die Adhäsionsneigung nimmt dadurch zu. Eine Aufrauhung der Oberfläche tritt automatisch durch Abnutzung und Verschleiß auf.

Zur Verhinderung ist es im Stand der Technik bekannt, die formgebenden Oberflächen mit einer Hartchromschicht oder poliertem Hartstahl zu versehen. Derartige galvanisch aufgebrachte Hartverchromungen sind aber nach wie vor nicht ausreichend verschleißbeständig, schon aufgrund ihrer porösen Struktur. Ferner tritt das Problem auf, daß eine Übertragung von Chrom auf das Produkt nicht auszuschließen ist.

Es sind daher bereits verschiedene Ansätze entwickelt worden, bei denen durch Zugabe von pulverförmigen oder flüssigen Trennmitteln im Rohmaterial oder durch Bestäubungs- bzw. Sprüheinrichtungen das Anhaften von Rohmaterial am Preßwerkzeug und der Matrize verhindert werden soll. Abgesehen von dem zusätzlichen apparativen Aufwand, den solche Einrichtungen erfordern, werden dabei auch Fremdstoffe in das Produkt eingebracht. Dies ist insbesondere in der Pharma- und Lebensmittelindustrie sehr unerwünscht.

Fließfähige Feststoffe sind einerseits pulverförmige und/oder rieselfähige. Feststoffe und andererseits auch halbfeste pastöse Stoffe. Auch bei geringeren Adhäsionsneigungen gegenüber fließfähigen Feststoffen beim Pressen sollen keine Fremdstoffe in das fertige Produkt eingetragen werden.

Weitere Versuche zur Verbesserung bestehen darin, die Adhäsionsneigung zwischen Rohmaterial und Preßwerkzeug bzw. Matrize dadurch zu reduzieren, daß Vorverarbeitungsstufen bei der Herstellung des Rohmaterials eingesetzt werden, beispielsweise ein Vakuumgranulierungsverfahren bei der Herstellung von Brausetabletten. Diese Verfahren sind ebenfalls sehr kostenintensiv.

In der DE 296 19 564 U1 wird ein Tablettierwerkzeug mit einer adhäsionshemmenden Beschichtung vorgeschlagen. Die adhäsionshemmende bzw. adhäsionsreduzierende Schicht soll dabei aus einem Metall oder einem Element der vierten Hauptgruppe des Periodensystems oder aus verschiedenen Verbindungen bestehen. Einige der dort vorgeschlagenen Beschichtungen führen jedoch nachweislich nicht zu adhäsionsreduzierenden Wirkungen, ganz im Gegenteil. Durch sie wird die Adhäsion deutlich heraufgesetzt, z.B. bei metallischem Aluminium. Der Fachmann kann dieser Druckschrift daher keine konkreten Anregungen entnehmen.

Aufgabe der Erfindung ist es, ein Tablettierwerkzeug vorzuschlagen, das die Gratwanderung von reduzierter Adhäsionsneigung und Verschließfestigkeit sowie Lebensdauer besser übersteht.

Diese Aufgabe wird erfindungsgemäß dadurch gelöst, daß die Beschichtung aus amorphem Kohlenstoff in einem Kohlenstoffnetzwerk, dotiert zumindest mit Wasserstoff, Silizium und Sauerstoff, besteht.

Mit einer derartigen Beschichtung werden überraschend die Probleme aus dem Stand der Technik beseitigt. Eine derartige Beschichtung besitzt nämlich einerseits die Eigenschaft, besonders geringe Adhäsionsneigungen gegenüber fließfähigen Feststoffen zu besitzen, andererseits aber auch jene

Verschleißfestigkeit, die erforderlich ist, um eine Aufrauhung der Oberfläche während des Betriebes zu verhindern.

Es wird daher nicht nur ein die Hartverchromung hinsichtlich der Verschleißfestigkeit vollständig ersetzender Materialaustausch vorgenommen, der ein mindestens genauso verschleißfestes Tablettierwerkzeug schafft, sondern außerdem können mit diesem Tablettierwerkzung auch noch wesentlich verbesserte Endprodukte, also gepreßte Formkörper, hergestellt werden.

Amorphe Kohlenwasserstoffschichten, sind in anderem Zusammenhang auch als DLC-Schichten (diamond-like-carbon) bekannt und zum Beispiel in der EP 0 022 285 B1 beschrieben.

Bekannt aus der DE 44 17 235 A1 und der EP 0 625 588 A1 sind amorphe Kohlenwasserstoffschichten dotiert mit Stickstoff oder reinem Sauerstoff, die die Adhäsionsneigung des beschichteten Materials erhöhen, also dem vorliegend angestrebten Zweck zuwiderlaufen. Diskutiert werden auch andere Modifizierungen, wie zum Beispiels Fluor. Eine Modifizierung mit Fluor senkt zwar die Adhäsionsneigung, wäre aber für Tablettierwerkzeuge aufgrund unzureichender Lebensdauer der Beschichtung und zu geringer Verschleißfestigkeit wenig geeignet. Es war weder vermutet worden noch zu erwarten, daß sich mit modifizierten amorphen Kohlenwasserstoffschichten sogar Tablettierwerkzeuge beschichten lassen, denn beim Verpressen herrschen ganz andere physikalische Kräfte und Randbedingungen als bei eher typischen Fällen, bei denen verringerte Adhäsion gewünscht wird, z.B. bei Schmierungen in Lagern.

In Betracht kommt auch eine zusätzliche Dotierung mit Metallen, wie sie in anderem Zusammenhang in der EP 0 087 836 B1 diskutiert wurde. Hier im vorliegenden Fall kommt insbesondere eine Dotierung mit Titan, Wolfram, Chrom, Mangan, Nickel, Tantal, Aluminium, Vanadium, Cobalt, Beryllium, Zirkonium, Hafnium, Niob und/oder Molybdän

Die erfindungsgemäßen mit Silizium und Sauerstoff dotierten Kohlenwasserstoffschichten reduzieren das Anhaften des Rohmaterials am Preßwerkzeug dramatisch. Damit ergeben sich insbesondere für Tablettenstempel in Tablettiermaschinen zur Herstellung von pharmazeutischen Erzeugnissen erheblich längere Standzeiten. Gerade bei dieser ganz besonders bevorzugten Ausführungsform wird die Gratwanderung von reduzierter Adhäsionsneigung und Verschleißfestigkeit sowie optimaler Lebensdauer in idealer Weise erfüllt. Zu beachten ist dabei auch, daß weniger

Reinigungszyklen notwendig sind, da keine Produktreste mehr an den Stempeln anhaften. Zusätzlich entsteht eine deutlich verbesserte optische Produktqualität. Aufwendige Granulierungsverfahren wie im Stand der Technik können unterbleiben. Auch das bisher praktisch unvermeidliche Herstellen von Trenntabletten als Zwischenarbeitsgang kann vermieden werden. Ohne eine Umrüstung der bestehenden Maschinen - abgesehen von den neuen oder überarbeiteten Preßwerkzeugen - kann die Produktivität faktisch verdoppelt werden.

Mit diesen adhäsionshemmenden a-C:H:Si:O-Beschichtungen ist es auch möglich, komplizierte Prägemuster, selbst firmenspezifische Marken, fehlerfrei von der formgebenden Oberfläche des Preßwerkzeuges auf das Produkt zu übertragen. Selbst jene auch mit den ohnehin schon unerwünschten Trennmitteln problematisch bleibenden Bereiche können sauber geprägt werden, die zwischen erhabenen Bereiche des Prägestempels zurückgenommen sind, beispielsweise die Innenräume in Buchstaben wie A, B oder R.

Ein weiterer Vorteil ist, daß die Auswerferkräfte bei derartig beschichteten Matrizen deutlich reduziert werden können, die zum Entfernen des Produktes aus der Matrize nach ihrer Herstellung benötigt werden.

Besonders vorteilhaft ist es, wenn die Beschichtung Schichtdicken zwischen 0,1 und 10 µm aufweist. Diese Schichtdicken sind hinreichend stabil und andererseits auch noch kostengünstig herzustellen.

Die erfindungsgemäßen Preßwerkzeuge werden bevorzugt in einem PACVD-Prozeß beschichtet. Als Ausgangsverbindungen zur Abscheidung von a-C:H:Si:O werden siliziumhaltige Precursoren verwendet Die lonisierung der verwendeten Gase erfolgt bevorzugt über eine Hochfrequenzanregung etwa im Bereich vom 13,56 MHz oder über eine Mittelfrequenzanregung mit einer Anregungsfrequenz von 1 bis 1000 kHz. Typische Druckbereiche für die HF- und MF-Anregung liegen zwischen 0,1 und 2000 Pa.

Dabei setzt sich bevorzugt die a-C:H:Si:O-Schicht aus 10 - 70 at% Kohlenstoff, 5 - 40 at% Wasserstoff, 1 - 40 at% Silizium und 1 - 40 at% Sauerstoff zusammen.

Als Abscheideverfahren können beispielsweise auch die in der EP 0 625 588 A1 beschriebenen Verfahren Verwendung finden, auf die hier ausdrücklich Bezug genommen wird.

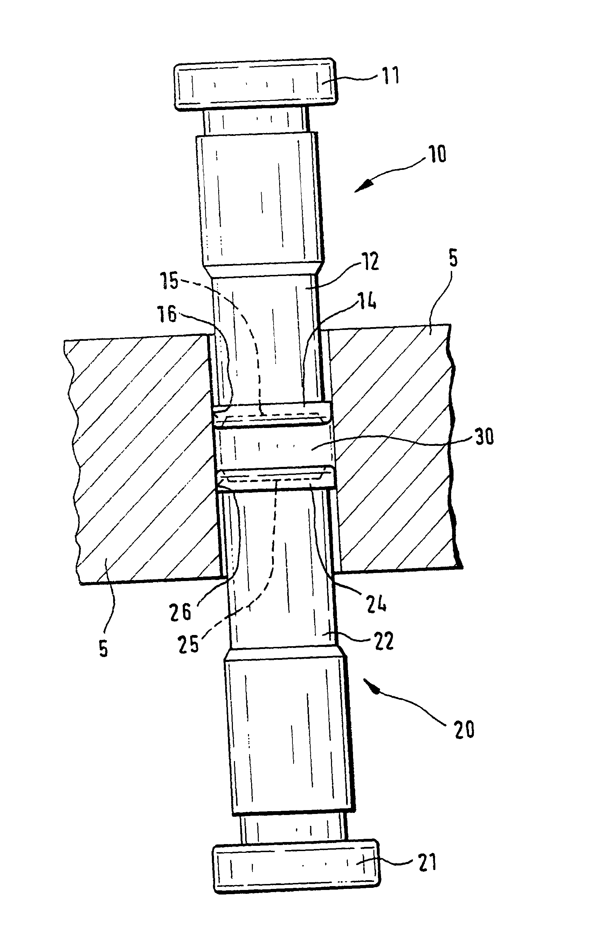

- **Figur 1**: Zeigt eine rein schematische und nicht maßstabsgetreue Darstellung eines Tablettiewerhzeuges.

Zu erkennen ist das Gehäuse 5 im Schnitt mit der Matrizenöffnung durchgehend in der Mitte. In die Matrizenöffnung fahren von oben der Oberstempel 10 und von unten der Unterstempel 20 ein. Zwischen Oberstempel 10 und Unterstempel 20 wird das Produkt, beispielsweise die Tablette, durch einen Preßvorgang geformt. Hierzu wird das fließfähige Material, beispielsweise ein pulverförmiger Stoff, in den Zwischenraum 30 eingebracht. Dies kann entweder von der Seite durch eine nicht dargestellte Öffnung erfolgen oder aber vor Einfahren des Oberstempels 10 von oben. Oberstempel 10 und Unterstempel 20 sind ähnlich aufgebaut. Beide besitzen jeweils einen Kopf 11 bzw. 21 und einen Schaft 12 bzw. 22. An den Schaft 12 schließt sich der formgebende Teil 14 und an den Schaft 22 der formgebende Teil 24 an. Sämtliche Teile sind zylindrisch ausgebildet und gleiten in der ebenfalls zylindrischen Matrizenöffnung.

In den beiden formgebenden Teilen 14 und 24 ist jeweils ein Hohlraum 15 bzw. 25 vorgesehen. Diese beiden Hohlräume gemeinsam bestimmen das Tablettenvolumen und die Tablettenform nach der Herstellung. Sie sind hier gestrichelt angedeutet, können ebenfalls zylindrisch sein, aber auch andere Formgebungsmöglichkeiten sind realisierbar.

Die Oberflächen der Hohlräume 15 bzw. 25 in den formgebenden Teilen 14 bzw. 24 sind die eigentlichen formgebenden Oberflächen, wenn beim Preßvorgang Oberstempel 10 und Unterstempel 20 in die Matrize der Tablettenpresse gefahren und gegeneinander gedrückt werden. Die seitliche Begrenzung der Tabletten erfolgt dabei in bekannter Weise durch die zylindrische Innenfläche der Matrizenöffnung.

Die formgebenden Oberflächen der Hohlräume 15 und 25 und ggf. auch die seitlichen Mantelflächen 16 bzw. 26 an den formgebenden Teilen 14 bzw. 24 können mit der erfindungsgemäßen Beschichtung über zoger sein Diese Schicht kann beispielsweise 2,5 µm dick sein

Diese Beschichtung kann sich auch auf weiteren Bestandteilen von Oberstempel 10 und Unterstempel 20 befinden.

### Bezugszeichenliste

- 5: Gehäuse
- 10: Oberstempel
- 11: Kopf
- 12: Schaft
- 14: ormgebendes Teil
- 15: Hohlraum
- 16: Mantelfläche
- 20: Unterstempel
- 21: Kopf
- 22: Schaft
- 24: formgebendes Teil
- 25: Hohlraum
- 26: Mantelfläche
- 30: Zwischenraum

## Patentansprüche

1. Tablettierwerkzeug zum Verpressen von fließfähigen Feststoffen, insbesondere pulverförmigen Feststoffen, mit formgebenden Presswerkzeugen zu Tabletten, bei dem zumindest die formgebenden Oberflächen der Presswerkzeuge mit einer adhäsionshemmenden Beschichtung versehen sind,
**dadurch gekennzeichnet**
**dass** die Beschichtung aus amorphem Kohlenstoff in einem Kohlenstoffnetzwerk, dotiert zumindest mit Wasserstoff, Silizium und Sauerstoff, besteht.

2. Tablettierwerkzeug nach Anspruch 1,
**dadurch gekennzeichnet,**
**dass** in der Beschichtung die a-C:H:Si:O-Schicht 10-70 at-% Kohlenstoff, 5-40 at-% Wasserstoff, 1-40 at-% Silizium und 1-40 at-% Sauarstoff enthält.

3. Tablettierwerkzeug nach Anspruch 1 oder 2,
**dadurch gekennzeichnet,**
**dass** in der Beschichtung zusätzlich eine Dotierung mit einem Metall vorliegt.

4. Tablettierwerkzeug nach Anspruch 3,
**dadurch gekennzeichnet,**
**dass** das Metall Titan, Wolfram, Chrom, Mangan, Nickel, Tantal, Aluminium, Vanadium, Kobalt, Beryllium, Zirkonium, Hafnium, Niob und/oder Molybdän enthält.

5. Tablettierwerkzeug nach einem der vorstehenden Ansprüche,
**dadurch gekennzeichnet,**
**dass** die Schichtdecke der Beschichtung zwischen 0,1 µm und 10 µm beträgt.

6. Tablettierwerkzeug nach einem der vorstehenden Ansprüche,
**dadurch gekennzeichnet,**
**dass** nicht nur die formgebenden Oberflächen, sondern zusätzlich auch die Mantelfläche (16, 26) des beziehungsweise der Stempel (10, 20) mit der Beschichtung versehen sind.

## Claims

1. Tableting tool for the compressing to tablets of flowable solids, in particular powdery solids, with shaping press tools, in which at least the shaping surfaces of the press tools are provided with an adhesion-inhibiting coating,
**characterised in that**
the coating consists of amorphous carbon in a carbon network, doped at least with hydrogen, silicon and oxygen.

2. Tableting tool according to claim 1,
**characterised in that**
in the coating the a-C:H:Si:O layer contains 10 - 70 at% of carbon, 5 - 40 at% of hydrogen, 1 - 40 at% of silicon and 1 - 40 at% of oxygen.

3. Tableting tool according to claim 1 or 2,
**characterised in that**
there is present in the coating additionally a doping with a metal.

4. Tableting tool according to claim 3,
**characterised in that**
that the metal contains titanium, tungsten, chromium, manganese, nickel, tantalum, aluminium, vanadium, cobalt, beryllium, zirconium, hafnium, niobium and/or molybdenum.

5. Tableting tool according to any one of the preceding claims,
**characterised in that**
the coat thickness of the coating comes to between 0.1 µm and 10 µm.

6. Tableting tool according to any one of the preceding claims,
**characterised in that**
not only the shaping surfaces, but in addition also the generating surface (16, 26) of the punch or punches (10, 20) are provided with the coating.

## Revendications

1. Empreinte de préformage pour la compression de matières solides fluables, en particulier de matières solides pulvérulentes, avec des matrices de moulage en comprimés, dans laquelle au moins les surfaces de moulage des matrices sont dotées d'un revêtement anti-adhésif, **caractérisée en ce que** le revêtement se compose de carbone amorphe dans un réseau carboné, dopé au moins avec de l'hydrogène, du silicium et de l'oxygène.

2. Empreinte de préformage selon la revendication 1, **caractérisée en ce que**, dans le revêtement, la couche a-C:H:Si:O contient 10 à 70% atomique de carbone, 5 à 40% atomique d'hydrogène, 1 à 40% atomique de silicium et 1 à 40% atomique d'oxygène.

3. Empreinte de préformage selon la revendication 1 ou 2, **caractérisée en ce que**, dans le revêtement, il existe en outre un dopage avec un métal.

4. Empreinte de préformage selon la revendication 3, **caractérisée en ce que** le métal contient du titane, du tungstène, du chrome, du manganèse, du nickel, du tantale, de l'aluminium, du vanadium, du cobalt, du béryllium, du zirconium, du hafnium, du niobium et/ou du molybdène.

5. Empreinte de préformage selon l'une des revendications précédentes, **caractérisée en ce que** l'épaisseur du revêtement se situe entre 0,1 µm et 10 µm.

6. Empreinte de préformage selon l'une des revendications précédentes, **caractérisée en ce que** non seulement les surfaces de moulage, mais aussi en plus les gaines (16, 26) de ou des étampes (10, 20) sont munies du revêtement.
